# EUROPEAN PATENT APPLICATION

(11) **EP 4 750 234 A1**
(43) Date of publication of application: **27.05.2026**
(21) Application number: 25215409.1
(22) Date of filing: 12.11.2025
(51) Int. Cl.: H05K 7/14

(54) **MODULAR IT INFRASTRUCTURE**

(30) Priority: 15.11.2024 US 202463721414 P; 31.10.2025 US 202519376459
(71) Applicant: Vertiv Corporation, Westerville, OH 43082 (US)
(72) Inventor: BADOWSKI, Aaron, Westerville, 43082 (US); NIKOLIC, Antonio, Westerville, 43082 (US); CLAVIER, Chris, Westerville, 43082 (US); NICHOLSON, Trevor, Westerville, 43082 (US); EASTON, Clint, Westerville, 43082 (US); MENOCHE, John, Westerville, 43082 (US); CAMPBELL, Chris, Westerville, 43082 (US); CRUZ, Pablo, Westerville, 43082 (US); REINBOLT, Brad, Westerville, 43082 (US); ULSAKER, Jonathan, Westerville, 43082 (US)
(74) Representative: Bryn-Jacobsen, Caelia

(57) **Abstract**

A modular information technology infrastructure system can include a framework for being supported above one or more rows of computer equipment racks, a piping network supported by the framework for distributing cooling fluid to and from the computer equipment racks, a power network supported by the framework for providing power to the computer equipment racks, and a communications tray supported by the framework for facilitating communications to and from the computer equipment racks. The framework can be suspended from above and/or disposed atop a plurality of legs. The framework can be collapsible into a shipping configuration and expandable into an operations configuration. Two or more modules can be coupled in series and/or in parallel.

## Description

### CROSS-REFERENCE TO RELATED APPLICATION(S)

This application claims the benefit of U.S. Provisional Patent Application No. 63/721,414 filed November 15, 2024.

### TECHNICAL FIELD

The present disclosure relates generally to data centers and more specifically relates to data center infrastructure.

### BACKGROUND

Data center power and cooling density requirements, as well as data center demand generally, are rapidly increasing. This is resulting in the need to deploy new and retrofit data center infrastructure quickly and efficiently.

### SUMMARY

Applicant has created new and useful devices, systems and methods for modular information technology (IT) infrastructure. Modular IT infrastructure systems according to the disclosure can provide a simple yet highly flexible building block of the key elements for IT rack systems and/or related components (e.g., cooling distribution units, power distribution units, etc.), such as cooling fluid and power distribution, IT cable management, and air containment. Multiple modular IT infrastructure systems can be factory integrated and tested and then individually, or as a large single unit, shipped to a customer data center. The modular IT infrastructure systems can be unpackaged, assembled together, and disposed above one or more rows of IT racks and/or a space therefor. Once in place, modular IT infrastructure systems can be commissioned and IT racks can be moved into place and connected thereto. Factory integrated modular IT infrastructure systems according to the disclosure can reduce site design and manpower requirements and shorten overall project schedule.

In at least one example, a modular information technology infrastructure system according to the disclosure can include a framework which can be supported above one or more rows of computer equipment racks, a piping network supported by the framework for distributing cooling fluid to and from the computer equipment racks, a power network supported by the framework for providing power to the computer equipment racks, a communications tray supported by the framework for facilitating communications to and from the computer equipment racks, or any combination thereof. In at least one example, the framework can be suspended from above and/or disposed atop a plurality of legs extending upwardly from a floor. In at least one example, the system can include one or more extension frames coupled to the framework and disposed at least partially below the framework, at least partially above the framework, at least partially above and/or between two or more support legs, or any combination thereof. In at least one example, the framework and/or the extension frames can be foldable, telescoping, or otherwise collapsible, between a shipping configuration, such as to minimize shipping size, and an operations configuration. In at least one example, the framework and/or the extension frames can occupy less volume in the shipping configuration than in the operations configuration.

In at least one example, a modular information technology infrastructure system according to the disclosure can be coupled with one or more other modular information technology infrastructure systems, in series and/or parallel. In at least one example, a first end of a first framework can be coupled to a second end of a second framework, such as with a first piping network of the first framework coupled to a second piping network of the second framework, a first power network of the first framework coupled to a second power network of the second framework, a first communications tray of the first framework coupled to a second communications tray of the second framework, or any combination thereof. In at least one example, a first framework can be coupled to a second framework, such as with a first piping network of the first framework running parallel to a second piping network of the second framework, a first power network of the first framework running parallel to a second power network of the second framework, a first communications tray of the first framework running parallel to a second communications tray of the second framework, or any combination thereof. In at least one example, a plurality of modular information technology infrastructure systems according to the disclosure can be coupled with one another in series, or end-to-end, and/or two or more modular information technology infrastructure systems according to the disclosure can be coupled with one another in parallel.

In at least one example, the framework can have a length and the piping network, the power network, the communications tray, or any combination thereof, can run the length of the framework. In at least one example, the piping network can include a supply pipe, a return pipe, a plurality of piping drops for coupling the supply pipe and/or the return pipe with plumbing in the computer equipment racks, or any combination thereof. In at least one example, the piping drops can be positioned along the length of the framework and/or the piping network. In at least one example, the piping network, or the modular information technology infrastructure system generally, can include a drip tray positioned below the supply pipe and/or the return pipe. In at least one example, the supply pipe, the return pipe, the drip tray, or any combination thereof, can run horizontally and/or the length of the framework.

In at least one example, the power network can include one or more power busses, or other conductors, and/or a plurality of junctions for supplying power to each of the computer equipment racks. In at least one example, the junctions can be positioned along the length of the framework and/or the power buss, or conductor. In at least one example, the power buss can run horizontally and/or the length of the framework.

In at least one example, the framework can be positioned above two rows of computer equipment racks and an aisle between the two rows of computer equipment racks. In at least one example, the framework can be positioned between two rows of computer equipment racks and above an aisle between the two rows of computer equipment racks. In at least one example, the framework can be positioned between and above two rows of computer equipment racks and above an aisle between the two rows of computer equipment racks.

In at least one example, a modular information technology infrastructure system according to the disclosure can include one or more light fixtures for illuminating an aisle between two rows of computer equipment racks. In at least one example, the light fixture(s) can be coupled to the framework and/or the power network. In at least one example, a modular information technology infrastructure system according to the disclosure can include one or more panels for directing hot air from an aisle between two rows of computer equipment racks to a hot air return plenum.

In at least one example, a method of assembling information technology infrastructure can include building a framework, coupling a piping network to the framework, coupling a power network to the framework, testing the piping network and/or the power network, shipping the framework to a construction site, supporting the framework above a floor of the construction site, coupling the piping network with a cooling fluid supply system at the construction site, coupling the power network with a power supply system at the construction site, commissioning the piping network and/or the power network, installing at least one row of computer equipment racks below the framework, coupling the piping network to the computer equipment racks, coupling the power network to the computer equipment racks, or any combination thereof. In at least one example, supporting the framework above the floor of the construction site can include suspending the framework from above and/or coupling the framework atop a plurality of legs extending upwardly from the floor.

In at least one example, a method of assembling information technology infrastructure can include compressing the framework to a shipping configuration before shipping the framework to the construction site and/or expanding the framework to an operations configuration after shipping the framework to the construction site. In at least one example, the framework can occupy less space and/or have smaller outside dimensions in the shipping configuration than in the operations configuration.

In at least one example, a method of assembling information technology infrastructure can include, such as after shipping the framework to the construction site and/or before commissioning the piping network and the power network, coupling a first end of a first framework to a second end of a second framework, coupling a first piping network of the first framework to a second piping network of the second framework, coupling the first power network of the first framework to a second power network of the second framework, or any combination thereof. In at least one example, a method of assembling information technology infrastructure can include, such as after shipping the framework to the construction site and/or before commissioning the piping network and the power network, coupling a first framework parallel to a second framework, with a first piping network of the first framework running parallel to a second piping network of the second framework and/or a first power network of the first framework running parallel to a second power network of the second framework.

### BRIEF DESCRIPTION OF THE DRAWINGS

FIG. 1 is a perspective view of one of many examples of a modular information technology infrastructure system according to the disclosure.
FIG. 2 is an end elevation view of one of many examples of a modular information technology infrastructure system according to the disclosure.
FIG. 3 is a side elevation view of one of many examples of a modular information technology infrastructure system according to the disclosure.
FIG. 4 is a top plan view of one of many examples of a modular information technology infrastructure system according to the disclosure.
FIG. 5 is a perspective view of one of many examples of a module of a modular information technology infrastructure system according to the disclosure.
FIG. 6 is an end elevation view of another one of many examples of a modular information technology infrastructure system according to the disclosure.
FIG. 7 is a perspective view of one of many examples of a modular information technology infrastructure system according to the disclosure, shown being assembled.
FIG. 8 is a top plan view of another one of many examples of a modular information technology infrastructure system according to the disclosure.
FIG. 9 is a top plan view of yet another one of many examples of a modular information technology infrastructure system according to the disclosure.
FIG. 10 is a top plan view of still another one of many examples of a modular information technology infrastructure system according to the disclosure.
FIG. 11 is a side elevation view of another one of many examples of a modular information technology infrastructure system according to the disclosure.
FIG. 12 is a side elevation view of yet another one of many examples of a modular information technology infrastructure system according to the disclosure.
FIG. 13 is a side elevation view of still another one of many examples of a modular information technology infrastructure system according to the disclosure.
FIG. 14 is a top plan view of another one of many examples of a modular information technology infrastructure system according to the disclosure.
FIG. 15 is a top plan view of yet another one of many examples of a modular information technology infrastructure system according to the disclosure.
FIG. 16 is a side elevation view of another one of many examples of a modular information technology infrastructure system according to the disclosure.
FIG. 17 is a flow chart illustrating one of many examples of a method of assembling information technology infrastructure according to the disclosure.
FIG. 18 is an end elevation view of one of many examples of a modular information technology infrastructure system having an extension frame according to the disclosure.
FIG. 19 is a side view of another one of many examples of a modular information technology infrastructure system having an extension frame according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems and methods according to various examples of the present disclosure. Each block in a flowchart may represent a module, segment, or portion of one or more of such implementations. In some implementations, the subject matter noted in the block(s) might occur out of the order depicted in the figures. For example, blocks shown in succession may, in fact, be executed substantially concurrently.

Applicant has created new and useful devices, systems and methods for modular information technology (IT) infrastructure. Modular IT infrastructure systems according to the disclosure can provide a simple yet highly flexible building block of the key elements for IT rack systems and/or related components (e.g., cooling distribution units, power distribution units, etc.), such as cooling fluid and power distribution, IT cable management, and air containment. Multiple modular IT infrastructure systems can be factory integrated and tested and then individually, or as a large single unit, shipped to a customer data center. The modular IT infrastructure systems can be unpackaged, assembled together, and placed independently above one or more rows of IT racks. Once in place, modular IT infrastructure systems can be commissioned and then IT racks can be rolled into place and connected thereto. Factory integrated modular IT infrastructure systems according to the disclosure can reduce site design and manpower requirements and shorten overall project schedule.

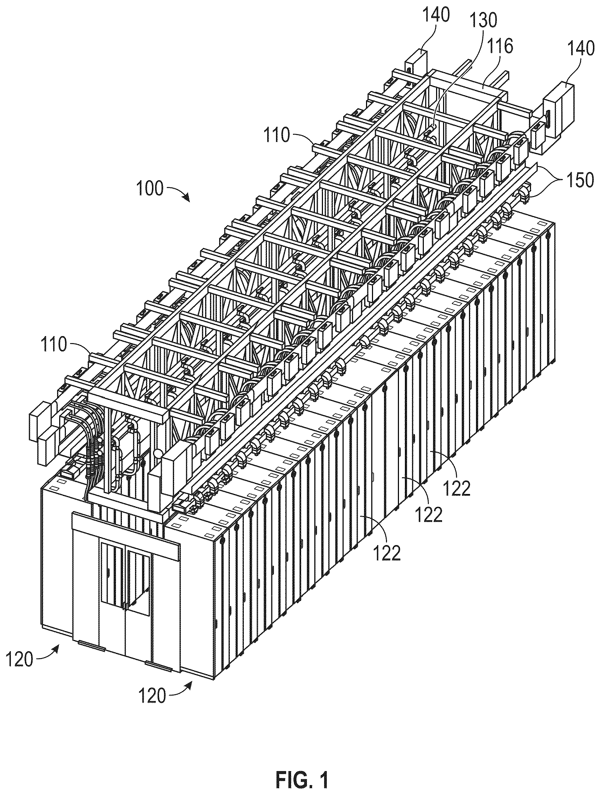

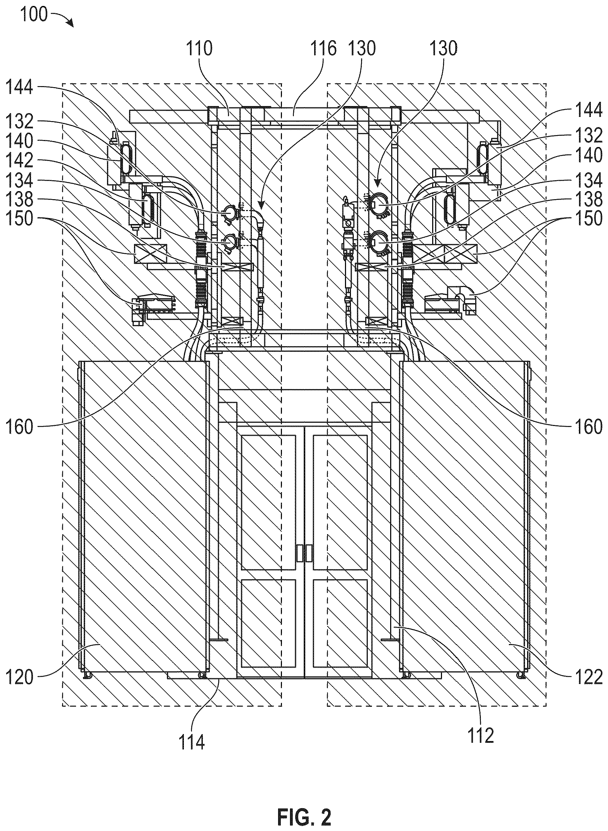

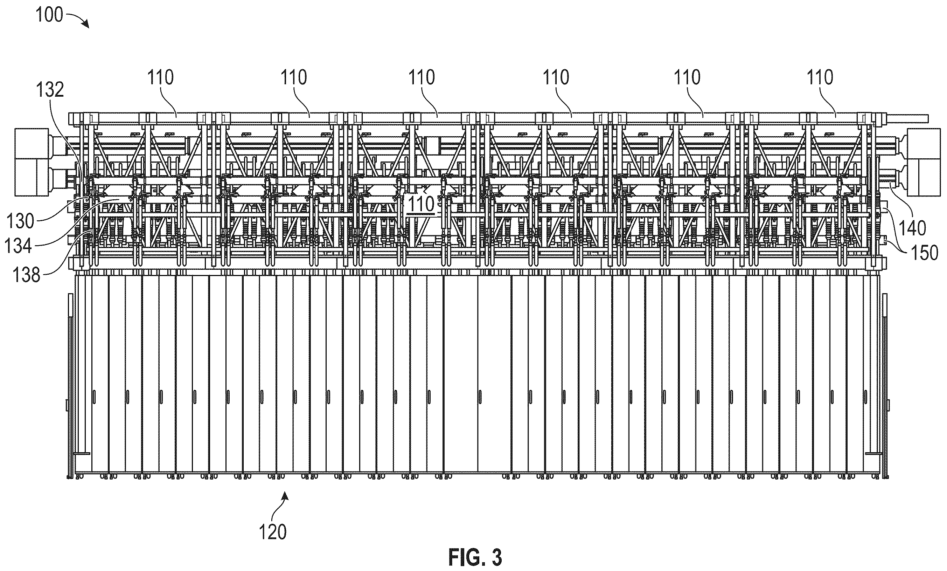

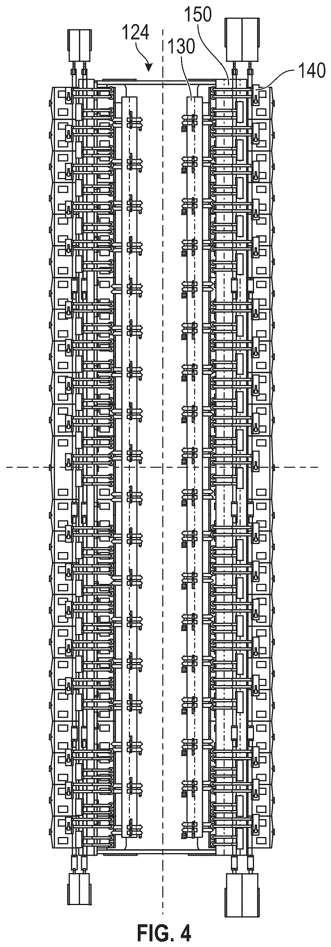

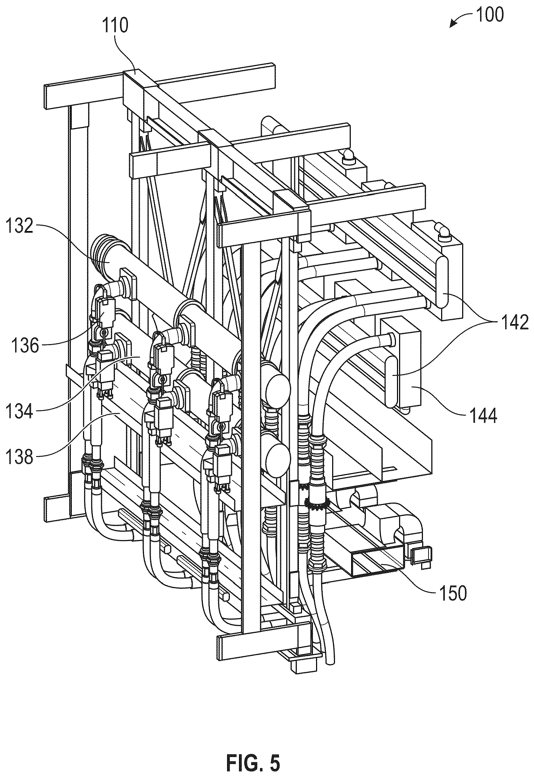

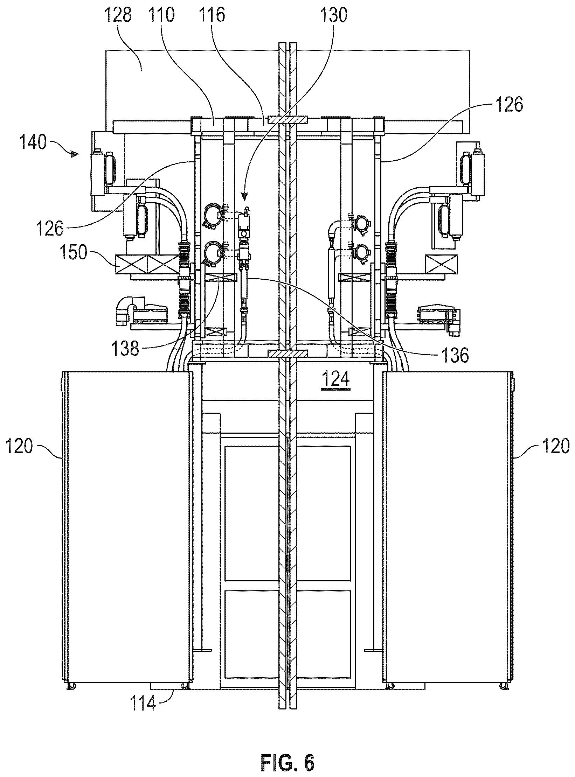

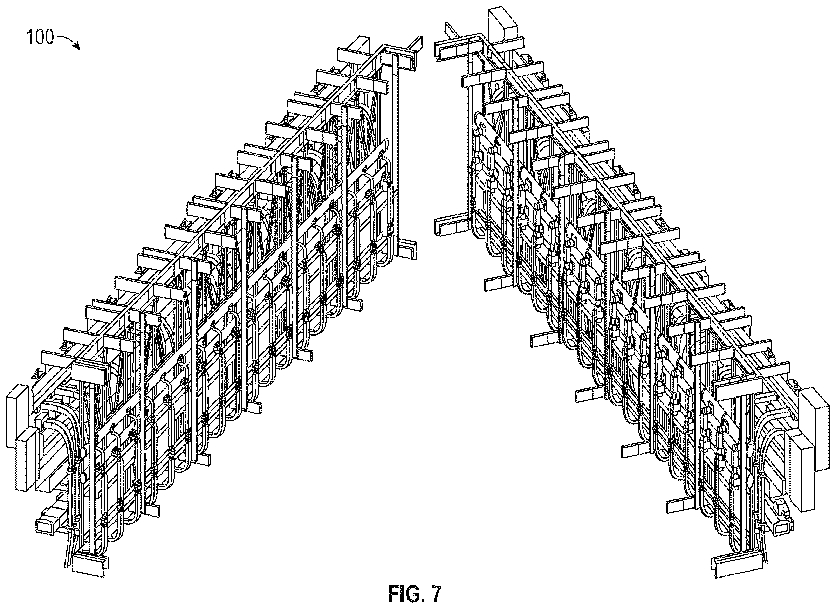

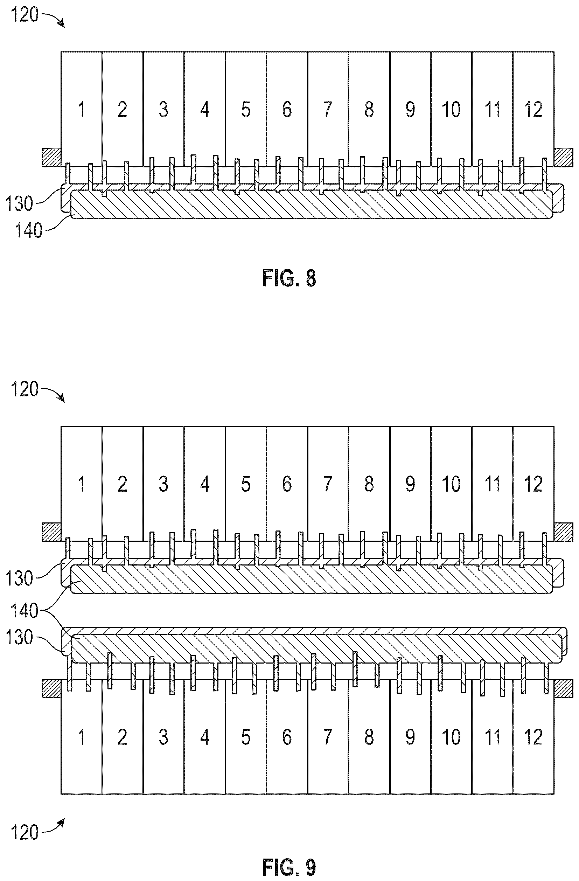

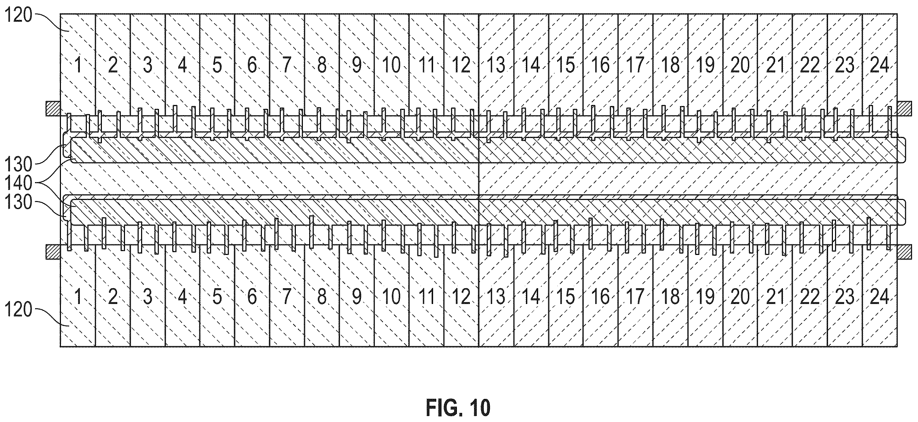

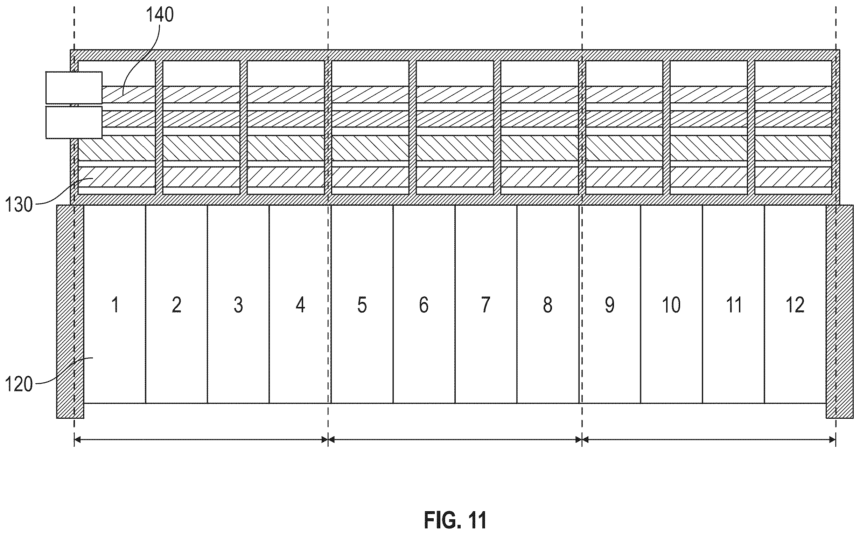

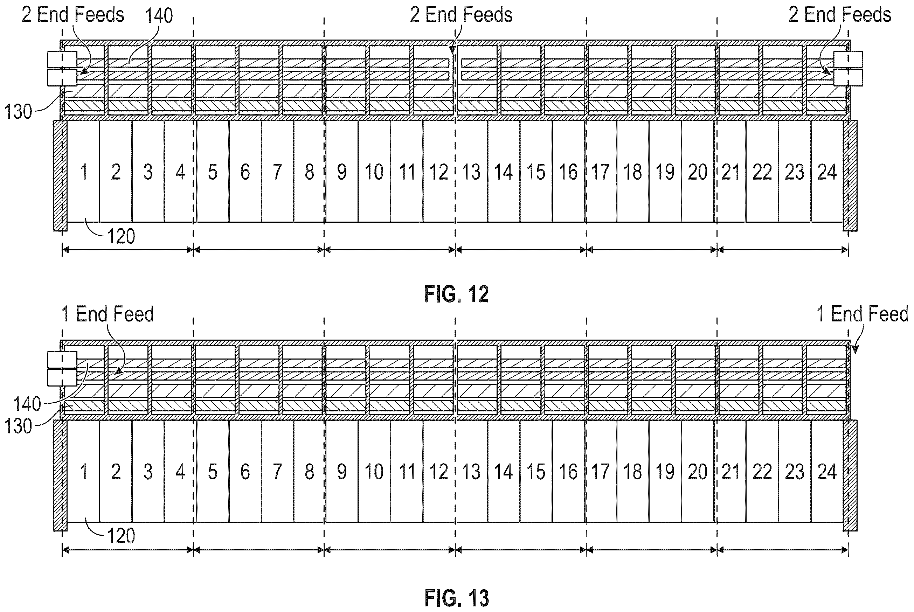

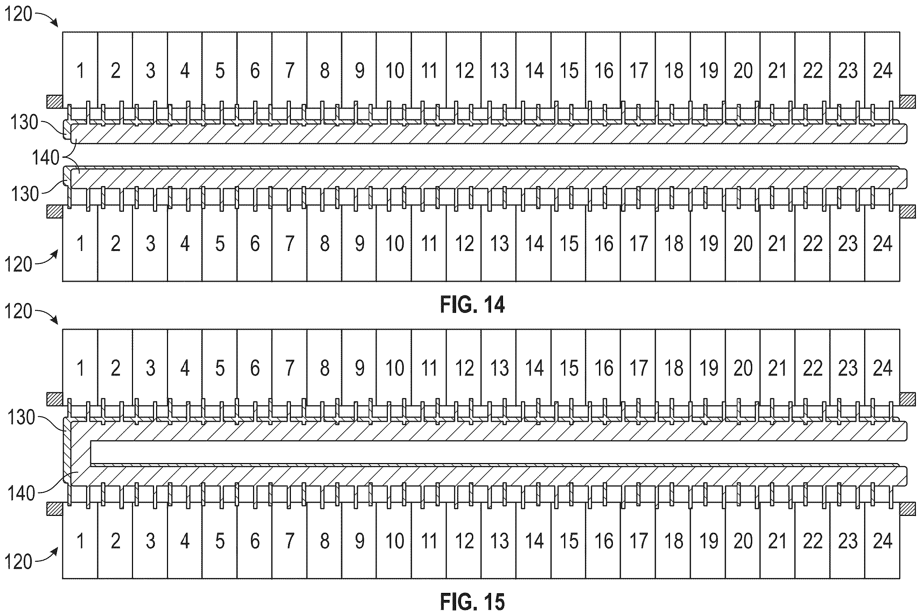

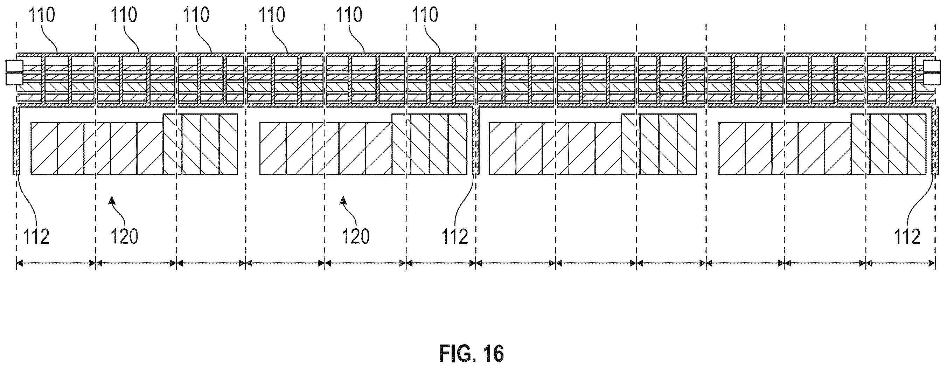

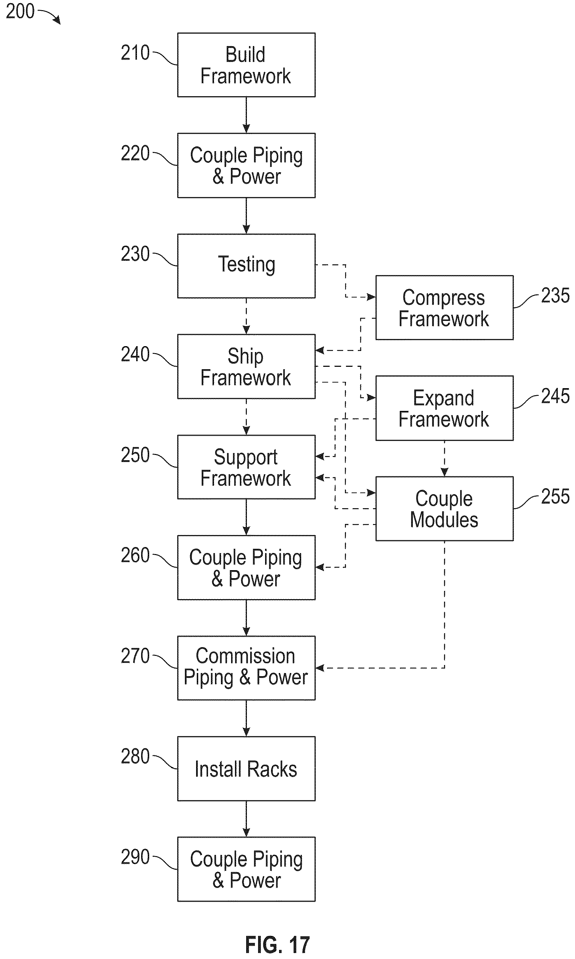

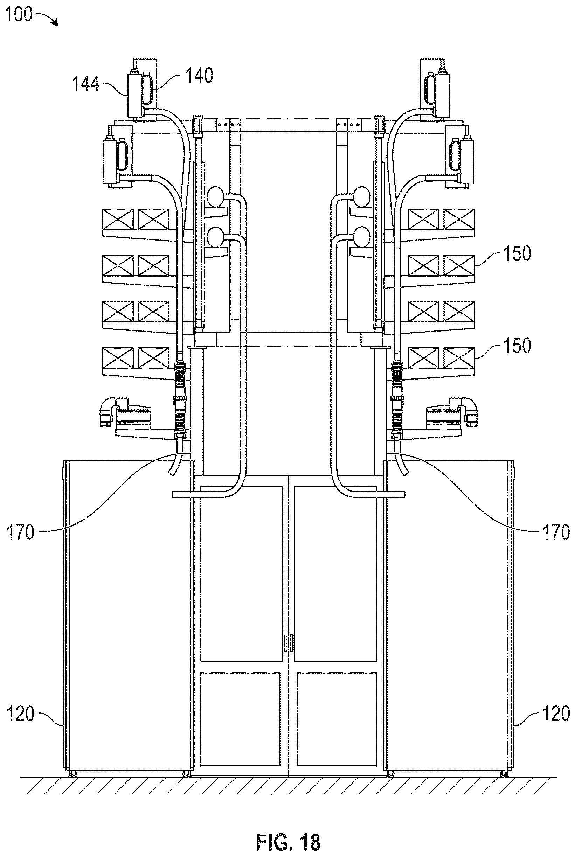

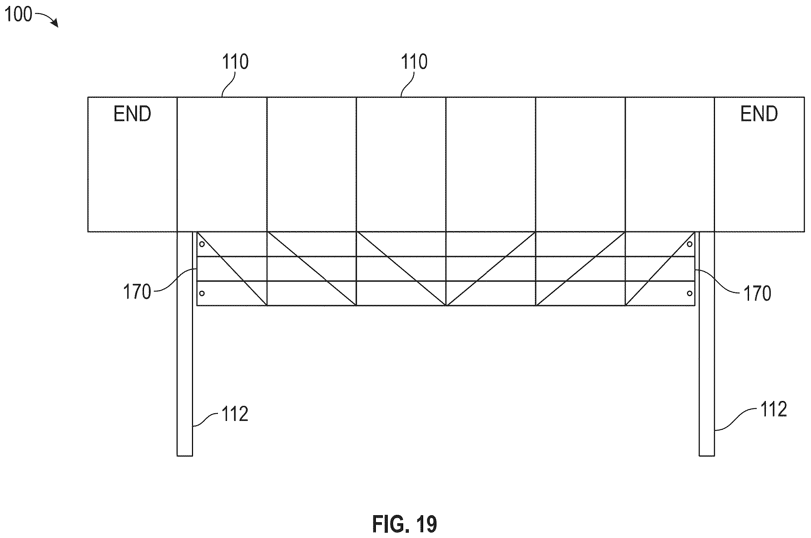

FIG. 1 is a perspective view of one of many examples of a modular information technology infrastructure system according to the disclosure. FIG. 2 is an end elevation view of one of many examples of a modular information technology infrastructure system according to the disclosure. FIG. 3 is a side elevation view of one of many examples of a modular information technology infrastructure system according to the disclosure. FIG. 4 is a top plan view of one of many examples of a modular information technology infrastructure system according to the disclosure. FIG. 5 is a perspective view of one of many examples of a module of a modular information technology infrastructure system according to the disclosure. FIG. 6 is an end elevation view of another one of many examples of a modular information technology infrastructure system according to the disclosure. FIG. 7 is a perspective view of one of many examples of a modular information technology infrastructure system according to the disclosure, shown being assembled. FIG. 8 is a top plan view of another one of many examples of a modular information technology infrastructure system according to the disclosure. FIG. 9 is a top plan view of yet another one of many examples of a modular information technology infrastructure system according to the disclosure. FIG. 10 is a top plan view of still another one of many examples of a modular information technology infrastructure system according to the disclosure. FIG. 11 is a side elevation view of another one of many examples of a modular information technology infrastructure system according to the disclosure. FIG. 12 is a side elevation view of yet another one of many examples of a modular information technology infrastructure system according to the disclosure. FIG. 13 is a side elevation view of still another one of many examples of a modular information technology infrastructure system according to the disclosure. FIG. 14 is a top plan view of another one of many examples of a modular information technology infrastructure system according to the disclosure. FIG. 15 is a top plan view of yet another one of many examples of a modular information technology infrastructure system according to the disclosure. FIG. 16 is a side elevation view of another one of many examples of a modular information technology infrastructure system according to the disclosure. FIG. 17 is a flow chart illustrating one of many examples of a method of assembling information technology infrastructure according to the disclosure. FIG. 18 is an end elevation view of one of many examples of a modular information technology infrastructure system having an extension frame according to the disclosure. FIG. 19 is a side view of another one of many examples of a modular information technology infrastructure system having an extension frame according to the disclosure. FIGS. 1-19 are described in conjunction with one another.

In at least one example, a modular information technology infrastructure system 100 according to the disclosure can include one or more frameworks 110 which can be supported above one or more rows 120 of computer equipment racks 122, one or more piping networks 130 supported by the framework 110 for distributing cooling fluid to and from the computer equipment racks 122, one or more power networks 140 supported by the framework 110 for providing power to the computer equipment racks 122, one or more communications trays 150 supported by the framework 110 for facilitating communications to and from the computer equipment racks 122, or any combination thereof. In at least one example, the framework(s) 110 and/or other system components can be suspended from above, such as from support structure in (or part of) a ceiling, and/or disposed atop a plurality of legs 112 extending upwardly from a floor 114. In at least one example, the framework(s) 110 and/or other system components can be disposed above one or more rows 120 of computer equipment racks 122 (and/or a space therefor, as the case may be) collectively as a complete assembly, in one or more pieces or subassemblies, temporarily during the installation process (e.g., via one or more temporary support columns or other structures), or any combination thereof.

In at least one example, a modular information technology infrastructure system 100 according to the disclosure can be or include one module and/or multiple modules, which can be identical or have differences therebetween. In at least one example, a modular information technology infrastructure system 100 according to the disclosure can be or include one independent module and/or be comprised of multiple modules, each of which can be independent or dependently coupled to one another. In at least one example, a modular information technology infrastructure system 100 according to the disclosure can be coupled with one or more other modular information technology infrastructure systems 100, in series and/or parallel. In at least one example, a modular information technology infrastructure system 100 according to the disclosure can be or include multiple identical modules in series and/or pairs of mirrored modules in parallel. In at least one example, a plurality of modular information technology infrastructure systems 100 according to the disclosure can be coupled with one another in series, or end-to-end, and/or two or more modular information technology infrastructure systems 100 according to the disclosure can be coupled with one another in parallel.

In at least one example, a first end of a first framework 110 can be coupled to a second end of a second framework 110, such as with a first piping network 130 of the first framework 110 coupled to a second piping network 130 of the second framework 110, a first power network 140 of the first framework 110 coupled to a second power network 140 of the second framework 110, a first communications tray 150 of the first framework 110 coupled to a second communications tray 150 of the second framework 110, or any combination thereof. In at least one example, the first framework 110, first piping network 130, first power network 140, first communications tray 150, or any combination thereof can be identical to the second framework 110, the second piping network 130, the second power network 140, the second communications tray 150, or any combination thereof, respectively.

In at least one example, a first framework 110 can be coupled to a second framework 110 in parallel, such as with one or more connecting, or cross, members 116. In at least one example, a first framework 110 can be coupled to a second framework 110, such as with a first piping network 130 of the first framework 110 running parallel to a second piping network 130 of the second framework 110, a first power network 140 of the first framework 110 running parallel to a second power network 140 of the second framework 140, a first communications tray 150 of the first framework 110 running parallel to a second communications tray 150 of the second framework 110, or any combination thereof. In at least one example, the first framework 110, first piping network 130, first power network 140, first communications tray 150, or any combination thereof can be a mirror image of, the second framework 110, the second piping network 130, the second power network 140, the second communications tray 150, respectively, or any combination thereof.

In at least one example, the framework 110 can have a length, such as in a longitudinal direction, and the piping network 130, the power network 140, the communications tray 150, or any combination thereof, can be disposed along the length of the framework 110 and/or otherwise can be at least roughly the same length as the framework 110. In at least one example, the framework 110 can be eight feet long and can be sized to fit through a standard door, such as by way of being three feet wide by seven feet tall. In at least one example, two frameworks 110, coupled to one another in parallel, can be eight feet long and can be sized to fit through a standard double door, such as by way of being six feet wide by seven feet tall. The foregoing dimensions are but some advantageous examples of many, and one or more frameworks 110 can have any dimensions required or desired for a given implementation of the disclosure.

In at least one example, the framework 110 can be foldable, telescoping, or otherwise collapsible between an operations configuration and a shipping configuration, such as for minimizing a shipping size of the framework 110. In at least one example, the framework 110 can occupy less space or volume in the shipping configuration than in the operations configuration, which can include having reduced dimensions in one or more directions. In at least one example, two or more portions of the framework 110 can fold and/or telescope with respect to one another. In at least one example, one or more outer dimensions of the framework 110 can be reduced for the shipping configuration, such as for shipping to a construction site, and then expanded to the operations configuration, such as for installation and/or commissioning.

In at least one example, the framework 110 can be eight feet long and arranged to fit through a standard door in either the shipping configuration or the operations configuration. In at least one example, the framework 110 can be eight feet long, arranged to fit through a standard door in the shipping configuration, and arranged to be expanded beyond the dimensions of the standard door in the operations configuration. In at least one example, two frameworks 110, coupled to one another in parallel, can be eight feet long and arranged to fit through a standard double door in either the shipping configuration or the operations configuration. In at least one example, two parallel frameworks 110 can be eight feet long, arranged to fit through a standard double door in the shipping configuration, and arranged to be expanded beyond the dimensions of the standard double door in the operations configuration. The foregoing dimensions are but some advantageous examples of many, and one or more frameworks 110 can have any dimensions required or desired for a given implementation of the disclosure.

In at least one example, the piping network 130 can include one or more supply pipes 132, one or more return pipes 134, one or more piping drops 136 for coupling the supply pipe 132 and/or the return pipe 134 with plumbing in the computer equipment racks 122, or any combination thereof. In at least one example, the piping drops 136 can be positioned along the length of the framework 110 and/or the piping network 130. In at least one example, the piping drops 136 can include one or more valves to selectively isolate each of the computer equipment racks 122, such as for making the computer equipment racks 122 hot swappable into and/or out of the piping network 130 of each module's framework 110. In at least one example, the piping network 130, or the modular information technology infrastructure system 100 generally, can include one or more drip trays 138 positioned below the supply pipe 132, the return pipe 134, the valves, or any combination thereof. In at least one example, the supply pipe 132, the return pipe 134, the drip tray 138, or any combination thereof, can run horizontally and/or along the length of the framework 110. In at least one example, one piping network 130 supported by one framework 110 can be coupled end-to-end to another piping network 130 supported by another framework 110. In at least one example, the piping network 130 can include one or more ultrasonic vibration units, such as on pipes, to agitate and dislodge contaminants, which can be captured or filtered by integrated filtration elements. In at least one example, the supply pipe 132 and/or the return pipe 134 can be four inches in diameter, six inches in diameter, between four and six inches in diameter, between two and ten inches in diameter, another dimension, or any combination thereof.

In at least one example, the power network 140 can include one or more conductors 142, such as power busses, and/or a plurality of junctions 144 for supplying power to each of the computer equipment racks 122. In at least one example, the junctions 144 can be or include one or more junction boxes, terminals, lugs, receptacles, other connections, or any combination thereof. In at least one example, the junctions 144 can be positioned along the length of the framework 110 and/or the power busses, or conductors 142. In at least one example, the conductors 142 can run horizontally and/or along the framework 110. In at least one example, the conductors 142 can be disposed in a horizontal or flat orientation, a vertical or on-edge orientation, an angled orientation, or any combination thereof.

In at least one example, the conductors 142 can be at least roughly the same length as the framework 110 and run along the length of the framework 110 and/or be offset therefrom. For example, in at least one example, the conductors 142 can run horizontally along the framework 110, extending beyond one end of the framework 110, to facilitate connection with another power network 140 of another framework 110. In at least one example, the conductors 142 can be at least roughly the same length as the framework and extend beyond one end of the framework 110, while not extending to (or being disposed short of) the other end of the framework 110. In at least one example, one power network 140 supported by one framework 110 can be coupled end-to-end to another power network 140 supported by another framework 110. In at least one example, the conductors 142 can be or include two to four busses, or other conductors, rated for between four hundred and one thousand amps each.

In at least one example, the communications trays 150 can include one or more trays for copper or other conductive cabling and/or one or more trays for fiberoptic or other non-conductive cabling. In at least one example, the communications trays 150 can be disposed parallel to one another, such as above one another and/or side-by-side. In at least one example, the communications trays 150 can run horizontally and/or along the length of the framework 110. In at least one example, one communication tray 150 supported by one framework 110 can be coupled end-to-end to another communication tray 150 supported by another framework 110. In at least one example, the communications trays 150 can include one or more trays five inches tall and twelve inches wide. In at least one example, the communications trays 150 can include one or more trays aligned end-to-end for a length of eight feet, for each framework 110. The foregoing dimensions are but some advantageous examples of many, and one or more communications trays 150 can have any dimensions required or desired for a given implementation of the disclosure.

In at least one example, one or more frameworks 110 can be disposed at least partially above one or more rows 120 of computer equipment racks 122 and/or an aisle 124 between the two rows 120 of computer equipment racks 122. In at least one example, one or more frameworks 110 can be disposed at least partially between two rows 120 of computer equipment racks 122 and at least partially above an aisle 124 between the two rows 120 of computer equipment racks 122. In at least one example, one or more frameworks 110 can be disposed at least partially between and above two rows 120 of computer equipment racks 122 and at least partially above an aisle 124 between the two rows 120 of computer equipment racks 122.

In at least one example, an aisle 124 between the two rows 120 of computer equipment racks 122 can be a hot aisle, such as for containing hot air expelled from the computer equipment racks 122. In at least one example, a modular information technology infrastructure system 100 according to the disclosure can include one or more panels 126 for directing hot air to one or more locations, such as from an aisle 124 between two rows 120 of computer equipment racks 122 to a hot air return plenum or duct 128. In at least one example, a modular information technology infrastructure system 100 according to the disclosure can include one or more panels 126 for directing cold air to one or more locations, such as from a cold air supply plenum or duct to an aisle 124 between two rows 120 of computer equipment racks 122. In at least one example, one or more panels 126 can be arranged for vertical air containment, horizontal air containment, angled air containment, or any combination thereof. In at least one example, one or more panels 126 can be disposed at least partially above the framework 110 (e.g., for in-row cooling), at least partially below the framework 110, at least partially within or beside the framework 110, or any combination thereof.

In at least one example, a modular information technology infrastructure system 100 according to the disclosure can include one or more light fixtures 160 for illuminating an aisle 124 between two rows 120 of computer equipment racks 122. In at least one example, the light fixture(s) 160 can be coupled to the framework 110 and/or the power network 140. In at least one example, the light fixture(s) 160 can be supported by the framework 110 and/or powered by the power network 140. In at least one example, the light fixture(s) 160 can be supported by the framework 110 indirectly, such as by being coupled to the communications tray 150 and/or drip tray 138.

In at least one example, a modular information technology infrastructure system 100 according to the disclosure can include one or more extension frames 170 for increasing or otherwise adjusting or compensating for vertical spacing or height-related considerations, and/or for otherwise supporting one or more other system components. In at least one example, one or more extension frames 170 can be coupled to the framework 110 and disposed at least partially above the framework 110, such as for occupying space above the framework 110 and/or coupling the framework 110 to supporting structure (e.g., beams, ceiling joints, etc.) disposed above the framework 110. In at least one example, one or more extension frames 170 can be coupled to the framework 110 and disposed at least partially below the framework 110, such as for occupying space beneath the framework 110 (e.g., between the framework 110 and one or more racks 122) and/or coupling the framework 110 to supporting structure (e.g., one or more legs 112) disposed beneath or beside the framework 110. For example, in at least one example, one or more extension frames 170 can hang from the framework 110, such as above one or more rows 120 and/or racks 122, and/or can be arranged for supporting one or more other system components above the rows 120 and/or racks 122. As another example, in at least one example, one or more extension frames 170 can be disposed beneath the framework 110 and coupled to one or more legs 112 for structurally supporting the framework 110 and/or one or more other system components.

In at least one example, one or more extension frames 170 can be foldable, telescoping, or otherwise collapsible between an operations configuration and a shipping configuration, such as for minimizing a shipping size of the extension frame 170. In at least one example, the extension frame 170 can occupy less space or volume in the shipping configuration than in the operations configuration, which can include having reduced dimensions in one or more directions. In at least one example, two or more portions of the extension frame 170 can fold and/or telescope with respect to one another. In at least one example, one or more outer dimensions of the extension frame 170 can be reduced for the shipping configuration, such as for shipping to a construction site, and then expanded to the operations configuration, such as for installation and/or commissioning. In at least one example, one or more extension frames 170 can be foldable, telescoping, or otherwise adjustable between or among a plurality of different operations configurations, which can facilitate installation of the framework 110 in any of a plurality of different vertical spacing configurations.

In at least one example, a method 200 of assembling information technology infrastructure can include building a framework 110, as shown in step 210, coupling a piping network 130 and/or a power network 140 to the framework 110, as shown in step 220, testing the piping network 130 and/or the power network 140, as showing in step 230, shipping the framework 110 to a construction site, as shown in step 240, or any combination thereof. In at least one example, the method 200 can include supporting the framework 110 above a floor 114 of the construction site, as shown in step 250, coupling the piping network 130 with a cooling fluid supply system at the construction site and/or the power network 140 with a power supply system at the construction site, as shown in step 260, commissioning the piping network 130 and/or the power network 140, as shown in step 270, or any combination thereof. In at least one example, the first framework can be supported above a floor of the construction site, in a temporary position, and the first piping network can be coupled with a cooling fluid supply system and/or the first power network can be coupled with a power supply system before supporting the first framework above a floor of the construction site in a final or installed position. In at least one example, the first piping network can be coupled with a cooling fluid supply system and/or the first power network can be coupled with a power supply system after supporting or disposing the first framework in a final or installed position.

In at least one example, the method 200 can include installing at least one row 120 of computer equipment racks 122 below the framework 110, as shown in step 280, coupling the piping network 130 and/or the power network 140 to the computer equipment racks 122, as shown in step 290, or any combination thereof. In at least one example, supporting the framework 110 above the floor 114 of the construction site can include suspending the framework 110 from above and/or coupling the framework 110 atop a plurality of legs 112 extending upwardly from the floor 114.

In at least one example, a method 200 of assembling information technology infrastructure can include compressing or collapsing the framework 110 into a shipping configuration, as shown in step 235, such as before shipping the framework 110 to the construction site, and/or expanding or extending the framework 110 into an operations configuration, as shown in step 245, such as after shipping the framework 110 to the construction site. In at least one example, the framework 110 can occupy less volume or space in the shipping configuration than in the operations configuration.

In at least one example, a method 200 of assembling information technology infrastructure can include, such as after shipping the framework 110 to the construction site and/or before commissioning the piping network 130 and/or the power network 140, coupling one module to another, and/or coupling multiple modules to one another, as shown in step 255. In at least one example, coupling one module to another and/or coupling multiple modules to one another can include coupling a first end of a first framework 110 to a second end of a second framework 110, coupling a first piping network 130 of the first framework 110 to a second piping network 130 of the second framework 110, coupling the first power network 140 of the first framework 110 to a second power network 140 of the second framework 110, or any combination thereof. In at least one example, coupling one module to another and/or coupling multiple modules to one another can include coupling a first framework 110 parallel to a second framework 110, with a first piping network 130 of the first framework 110 running parallel to a second piping network 130 of the second framework 110 and/or a first power network 140 of the first framework 110 running parallel to a second power network 140 of the second framework 110.

In at least one example, a modular information technology infrastructure system 100 according to the disclosure can be or include one or more preassembled modules, each having one or more frameworks 110 supporting piping networks 130, power networks 140, communication trays 150, or any combination thereof. In at least one example, each preassembled module can be collapsable to, e.g., as small as eight feet long, six and one half feet tall, and four and one half feet wide, or smaller, such as for retrofit applications. In at least one example, a modular information technology infrastructure system 100 according to the disclosure can include multiple frameworks 110 extending up to forty-eight feet between legs 112 in single or dual row configurations. In at least one example, a modular information technology infrastructure system 100 according to the disclosure can operate in clusters, such as independently, and/or pods, with no large breaks between computer equipment racks 122 and/or modules.

In at least one example, a modular information technology infrastructure system 100 according to the disclosure can include one or more sliding ladders, such as those commonly found in wine cellars and/or libraries, and/or permanent or temporary scaffolding for providing access to components of the systems 100. In at least one example, a modular information technology infrastructure system 100 according to the disclosure can include components otherwise found in more traditional data center coolant distribution units and/or air handling units, such as one or more pumps, one or more fans, one or more air and/or coolant filtering units, one or more coolant tanks, or any combination thereof. In at least one example, a modular information technology infrastructure system 100 according to the disclosure can be arranged for integration with one or more other modular systems or components, can include and/or be operably coupled with one or more remote and/or other power panels, can be configurable via a configurator, or any combination thereof.

In at least one example, a modular information technology infrastructure system according to the disclosure can include a framework which can be supported above one or more rows of computer equipment racks, a piping network supported by the framework for distributing cooling fluid to and from the computer equipment racks, a power network supported by the framework for providing power to the computer equipment racks, a communications tray supported by the framework for facilitating communications to and from the computer equipment racks, or any combination thereof. In at least one example, the framework can be suspended from above and/or disposed atop a plurality of legs extending upwardly from a floor. In at least one example, the system can include one or more extension frames coupled to the framework and disposed at least partially below the framework, at least partially above the framework, at least partially above and/or between two or more support legs, or any combination thereof. In at least one example, the framework and/or the extension frames can be foldable, telescoping, or otherwise collapsible, between a shipping configuration, such as to minimize shipping size, and an operations configuration. In at least one example, the framework and/or the extension frames can occupy less volume in the shipping configuration than in the operations configuration.

In at least one example, a modular information technology infrastructure system according to the disclosure can be coupled with one or more other modular information technology infrastructure systems, in series and/or parallel. In at least one example, a first end of a first framework can be coupled to a second end of a second framework, such as with a first piping network of the first framework coupled to a second piping network of the second framework, a first power network of the first framework coupled to a second power network of the second framework, a first communications tray of the first framework coupled to a second communications tray of the second framework, or any combination thereof. In at least one example, a first framework can be coupled to a second framework, such as with a first piping network of the first framework running parallel to a second piping network of the second framework, a first power network of the first framework running parallel to a second power network of the second framework, a first communications tray of the first framework running parallel to a second communications tray of the second framework, or any combination thereof. In at least one example, a plurality of modular information technology infrastructure systems according to the disclosure can be coupled with one another in series, or end-to-end, and/or two or more modular information technology infrastructure systems according to the disclosure can be coupled with one another in parallel.

In at least one example, the framework can have a length, with the piping network, the power network, the communications tray, or any combination thereof, running the length of the framework. In at least one example, the piping network can include a supply pipe, a return pipe, a plurality of piping drops for coupling the supply pipe and/or the return pipe with plumbing in the computer equipment racks, or any combination thereof. In at least one example, the piping drops can be positioned along the length of the framework and/or the piping network. In at least one example, the piping network, or the modular information technology infrastructure system generally, can include a drip tray positioned below the supply pipe and/or the return pipe. In at least one example, the supply pipe, the return pipe, the drip tray, or any combination thereof, can run horizontally and/or the length of the framework.

In at least one example, the power network can include one or more power busses, or other conductors, and/or a plurality of junctions for supplying power to each of the computer equipment racks. In at least one example, the junctions can be positioned along the length of the framework and/or the power buss, or conductor. In at least one example, the power buss can run horizontally and/or the length of the framework.

In at least one example, the framework can be positioned above two rows of computer equipment racks and an aisle between the two rows of computer equipment racks. In at least one example, the framework can be positioned between two rows of computer equipment racks and above an aisle between the two rows of computer equipment racks. In at least one example, the framework can be positioned between and above two rows of computer equipment racks and above an aisle between the two rows of computer equipment racks.

In at least one example, a modular information technology infrastructure system according to the disclosure can include one or more light fixtures for illuminating an aisle between two rows of computer equipment racks. In at least one example, the light fixture(s) can be coupled to the framework and/or the power network. In at least one example, a modular information technology infrastructure system according to the disclosure can include one or more panels for directing hot air from an aisle between two rows of computer equipment racks to a hot air return plenum.

In at least one example, a method of assembling information technology infrastructure can include building a framework, coupling a piping network to the framework, coupling a power network to the framework, testing the piping network and/or the power network, shipping the framework to a construction site, supporting the framework above a floor of the construction site, coupling the piping network with a cooling fluid supply system at the construction site, coupling the power network with a power supply system at the construction site, commissioning the piping network and/or the power network, installing at least one row of computer equipment racks below the framework, coupling the piping network to the computer equipment racks, coupling the power network to the computer equipment racks, or any combination thereof. In at least one example, supporting the framework above the floor of the construction site can include suspending the framework from above and/or coupling the framework atop a plurality of legs extending upwardly from the floor. In at least one example, the first framework can be supported above a floor of the construction site, in a temporary position, and the first piping network can be coupled with a cooling fluid supply system and/or the first power network can be coupled with a power supply system before supporting the first framework above a floor of the construction site in a final or installed position. In at least one example, the first piping network can be coupled with a cooling fluid supply system and/or the first power network can be coupled with a power supply system after supporting or disposing the first framework in a final or installed position.

In at least one example, a method of assembling information technology infrastructure can include compressing the framework to a shipping configuration before shipping the framework to the construction site and/or expanding the framework to an operations configuration after shipping the framework to the construction site. In at least one example, the framework can occupy less volume in the shipping configuration than in the operations configuration.

In at least one example, a method of assembling information technology infrastructure can include, such as after shipping the framework to the construction site and/or before commissioning the piping network and the power network, coupling a first end of a first framework to a second end of a second framework, coupling a first piping network of the first framework to a second piping network of the second framework, coupling the first power network of the first framework to a second power network of the second framework, or any combination thereof. In at least one example, a method of assembling information technology infrastructure can include, such as after shipping the framework to the construction site and/or before commissioning the piping network and the power network, coupling a first framework parallel to a second framework, with a first piping network of the first framework running parallel to a second piping network of the second framework and/or a first power network of the first framework running parallel to a second power network of the second framework.

Other and further examples utilizing one or more aspects of the disclosure can be devised. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. A modular information technology infrastructure system comprising:
   a first framework configured to be supported above at least one row of computer equipment racks;
   a first piping network supported by the first framework for distributing cooling fluid to and from the computer equipment racks;
   a first power network supported by the first framework for providing power to the computer equipment racks; and
   a first communications tray supported by the first framework for facilitating communications to and from the computer equipment racks.
2. The system as set forth in clause 1, wherein the first framework is configured to be suspended from above.
3. The system as set forth in any one of the preceding clauses, wherein the first framework is configured to be disposed atop a plurality of legs extending upwardly from a floor.
4. The system as set forth in any one of the preceding clauses wherein the first framework is foldable between a shipping configuration and an operations configuration; and wherein the framework occupies less volume in the shipping configuration than in the operations configuration.
5. The system as set forth in any one of the preceding clauses, wherein the first framework is collapsible between a shipping configuration and an operations configuration; and wherein the framework occupies less volume in the shipping configuration than in the operations configuration.
6. The system as set forth in any one of the preceding clauses, wherein the first framework is configured to telescope between a shipping configuration and an operations configuration; and wherein the framework occupies less volume in the shipping configuration than in the operations configuration.
7. The system as set forth in any one of the preceding clauses, wherein a first end of the first framework is configured to be coupled to a second end of a second framework, with the first piping network coupled to a second piping network of the second framework and the first power network coupled to a second power network of the second framework.
8. The system as set forth in any one of the preceding clauses, wherein the first framework is configured to be coupled to a second framework, with the first piping network running parallel to a second piping network of the second framework, the first power network running parallel to a second power network of the second framework, and the first communications tray running parallel to a second communications tray of the second framework.
9. The system as set forth in any one of the preceding clauses, wherein the first framework has a length and wherein the first piping network, the first power network, and the first communications tray run the length of the framework.
10. The system as set forth in clause 9, wherein the first piping network comprises a horizontal supply pipe running the length of the framework, a horizontal return pipe running the length of the framework, and a plurality of piping drops configured to couple the horizontal supply pipe and the horizontal return pipe with plumbing in the computer equipment racks.
11. The system as set forth in clause 10, further comprising a drip tray positioned below the horizontal supply pipe and the horizontal return pipe.
12. The system as set forth in clause 9, wherein the first power network comprises a horizontal power buss and a plurality of junctions positioned along the horizontal power buss for supplying power to each of the computer equipment racks.
13. The system as set forth in any one of the preceding clauses, wherein the first framework is configured to be positioned above two rows of computer equipment racks and an aisle disposed between the two rows of computer equipment racks.
14. The system as set forth in clause 13, further comprising at least one light fixture configured to illuminate the aisle.
15. The system as set forth in clause 14, wherein the at least one light fixture is coupled to the first power network.
16. The system as set forth in clause 13, further comprising a plurality of panels configured to direct hot air from the aisle to a hot air return plenum.
17. A method of assembling information technology infrastructure, the method comprising:
   building a first framework;
   coupling a first piping network to the first framework;
   coupling a first power network to the first framework;
   testing the first piping network and the first power network;
   shipping the first framework to a construction site;
   coupling the first piping network with a cooling fluid supply system at the construction site;
   coupling the first power network with a power supply system at the construction site;
   supporting the first framework above a floor of the construction site;
   commissioning the first piping network and the first power network;
   installing at least one row of computer equipment racks below the first framework;
   coupling the first piping network to the at least one row of computer equipment racks; and
   coupling the first power network to the at least one row of computer equipment racks.
18. The method as set forth in clause 17, wherein supporting the first framework above the floor of the construction site comprises suspending the first framework from above.
19. The method as set forth in clause 17 or 18, wherein supporting the first framework above the floor of the construction site comprises coupling the first framework atop a plurality of legs extending upwardly from the floor.
20. The method as set forth in any one of clauses 17-19, further comprising:
   compressing the first framework to a shipping configuration before shipping the first framework to the construction site; and
   expanding the first framework to an operations configuration after shipping the first framework to the construction site;
   wherein the first framework occupies less volume in the shipping configuration than in the operations configuration.
21. The method as set forth in any one of clauses 17-20, further comprising, after shipping the first framework to the construction site and before commissioning the first piping network and the first power network:
   coupling a first end of the first framework to a second end of a second framework;
   coupling the first piping network to a second piping network of the second framework; and
   coupling the first power network to a second power network of the second framework.
22. The method as set forth in any one of clauses 17-21, further comprising, after shipping the first framework to the construction site and before commissioning the first piping network and the first power network:
   coupling the first framework parallel to a second framework, with the first piping network running parallel to a second piping network of the second framework and the first power network running parallel to a second power network of the second framework.
23. The system as set forth in any one of clauses 1-16, further comprising one or more extension frames coupled to the first framework.
24. The system as set forth in clause 23, wherein the one or more extension frames are configured to be disposed at least partially above the first framework, at least partially below the first framework, or both.
25. A method as shown and/or described herein.
26. A system as shown and/or described herein.
27.A device as shown and/or described herein.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

## Claims

1. A modular information technology infrastructure system comprising:
a first framework configured to be supported above at least one row of computer equipment racks;
a first piping network supported by the first framework for distributing cooling fluid to and from the computer equipment racks;
a first power network supported by the first framework for providing power to the computer equipment racks; and
a first communications tray supported by the first framework for facilitating communications to and from the computer equipment racks.

2. The system as set forth in claim 1, wherein the first framework is configured to be suspended from above.

3. The system as set forth in any one of the preceding claims, wherein the first framework is configured to be disposed atop a plurality of legs extending upwardly from a floor.

4. The system as set forth in any one of the preceding claims wherein the first framework is foldable between a shipping configuration and an operations configuration; and wherein the framework occupies less volume in the shipping configuration than in the operations configuration.

5. The system as set forth in any one of the preceding claims, wherein the first framework is collapsible between a shipping configuration and an operations configuration; and wherein the framework occupies less volume in the shipping configuration than in the operations configuration.

6. The system as set forth in any one of the preceding claims, wherein the first framework is configured to telescope between a shipping configuration and an operations configuration; and wherein the framework occupies less volume in the shipping configuration than in the operations configuration; or optionally
wherein a first end of the first framework is configured to be coupled to a second end of a second framework, with the first piping network coupled to a second piping network of the second framework and the first power network coupled to a second power network of the second framework; or optionally
wherein the first framework is configured to be coupled to a second framework, with the first piping network running parallel to a second piping network of the second framework, the first power network running parallel to a second power network of the second framework, and the first communications tray running parallel to a second communications tray of the second framework.

7. The system as set forth in any one of the preceding claims, wherein the first framework has a length and wherein the first piping network, the first power network, and the first communications tray run the length of the framework.

8. The system as set forth in claim 7, wherein the first piping network comprises a horizontal supply pipe running the length of the framework, a horizontal return pipe running the length of the framework, and a plurality of piping drops configured to couple the horizontal supply pipe and the horizontal return pipe with plumbing in the computer equipment racks.

9. The system as set forth in claim 8, further comprising a drip tray positioned below the horizontal supply pipe and the horizontal return pipe.

10. The system as set forth in claim 7, wherein the first power network comprises a horizontal power buss and a plurality of junctions positioned along the horizontal power buss for supplying power to each of the computer equipment racks.

11. The system as set forth in any one of the preceding claims, wherein the first framework is configured to be positioned above two rows of computer equipment racks and an aisle disposed between the two rows of computer equipment racks.

12. The system as set forth in claim 11, further comprising at least one light fixture configured to illuminate the aisle; and optionally
wherein the at least one light fixture is coupled to the first power network.

13. The system as set forth in claim 11, further comprising a plurality of panels configured to direct hot air from the aisle to a hot air return plenum.

14. A method of assembling information technology infrastructure, the method comprising:
building a first framework;
coupling a first piping network to the first framework;
coupling a first power network to the first framework;
testing the first piping network and the first power network;
shipping the first framework to a construction site;
coupling the first piping network with a cooling fluid supply system at the construction site;
coupling the first power network with a power supply system at the construction site;
supporting the first framework above a floor of the construction site;
commissioning the first piping network and the first power network;
installing at least one row of computer equipment racks below the first framework;
coupling the first piping network to the at least one row of computer equipment racks; and
coupling the first power network to the at least one row of computer equipment racks.

15. The method as set forth in claim 14, wherein supporting the first framework above the floor of the construction site comprises suspending the first framework from above; or optionally
wherein supporting the first framework above the floor of the construction site comprises coupling the first framework atop a plurality of legs extending upwardly from the floor; or optionally
further comprising:
compressing the first framework to a shipping configuration before shipping the first framework to the construction site; and
expanding the first framework to an operations configuration after shipping the first framework to the construction site;
wherein the first framework occupies less volume in the shipping configuration than in the operations configuration.
